# EUROPEAN PATENT SPECIFICATION

(11) **EP 4 411 399 B1**
(45) Date of publication and mention of the grant of the patent: **18.11.2026**
(21) Application number: 22922685.7
(22) Date of filing: 26.01.2022
(51) Int. Cl.: G01R 31/382, G01R 31/396

(54) **BATTERY MONITORING METHOD AND BATTERY MONITORING DEVICE**
BATTERIEÜBERWACHUNGSVERFAHREN UND BATTERIEÜBERWACHUNGSVORRICHTUNG
PROCÉDÉ DE SURVEILLANCE DE BATTERIE ET DISPOSITIF DE SURVEILLANCE DE BATTERIE

(43) Date of publication of application: 07.08.2024
(73) Proprietor: Contemporary Amperex Technology (Hong Kong) Limited, Central, Central And Western District (HK)
(72) Inventor: HUANG, Shan, Ningde, Fujian 352100 (CN); LI, Shichao, Ningde, Fujian 352100 (CN); ZUO, Xiyang, Ningde, Fujian 352100 (CN)
(74) Representative: Ziebig Hengelhaupt Intellectual Property Attorneys Patentanwaltskanzlei PartGmbB
(86) International application number: PCT/CN2022/074111
(87) International publication number: WO 2023/141835

(56) References cited:
- EP-A1- 3 677 465
- WO-A1-2019/042399
- CN-A- 105 527 583
- CN-A- 110 015 179
- CN-A- 111 361 448
- CN-A- 112 083 342
- CN-B- 107 256 987
- DE-A1- 102015 116 102
- JP-A- 2021 162 511
- KR-A- 20120 114 584
- KR-A- 20200 143 019
- US-B2- 9 768 624

## Description

### TECHNICAL FIELD

The present application relates to the technical field of batteries, and more particularly, relates to a battery monitoring method and a battery monitoring device.

### BACKGROUND

A battery may experience a self-discharge process during storage, and even when it is not used. A self-discharge rate of the battery can be determined according to a calculation method in this field. For example, a state of charge (SOC) of the battery is obtained at the first time point, the SOC of the battery is obtained at a second time point, the self-discharge rate of the battery can be measured according to the difference value between the SOC of the first time point and the SOC of the second time point, and the time interval between the first time point and the second time point. However, the method for obtaining the self-discharge rate of the battery is usually carried out in a laboratory. For the batteries used in different scenes, it is difficult to monitor the self-discharge rates of these batteries.

Especially for the batteries that are used in different usage scenarios, such as the lithium ion batteries arranged in electric vehicles, if the self-discharge rates of the lithium ion batteries exceed a safety threshold, it means that the batteries may have a hidden danger. Therefore, a technical problem that it is difficult to monitor the self-discharge rate of the battery is existed. It is in urgent need of a solution for monitoring the self-discharge rate of the battery in order to improve the safety of usage of the battery. Documents EP3677465A1 and US9768624B2 disclose examples of approaches for monitoring battery self-discharge.

### SUMMARY

The invention is defined by a battery monitoring method according to claim 1, a battery monitoring device according to claim 8 and the associated computer readable storage medium according to claim 9. Further aspects are defined by the corresponding dependent claims.

### DESCRIPTION OF THE DRAWINGS

In order to describe the embodiments of the present application more clearly, a brief introduction regarding the accompanying drawings that need to be used for describing the embodiments of the present application is given below.
FIG. 1 illustrates a schematic diagram of a battery monitoring method provided in one or a plurality of embodiments of the present application;
FIG. 2 illustrates a schematic structural diagram of one battery monitoring device provided in one or a plurality of embodiments of the present application;
FIG. 3 illustrates a schematic structural diagram of another battery monitoring device provided in one or a plurality of embodiments of the present application.

### DETAILED DESCRIPTION OF EMBODIMENTS

The embodiments of the present application are further described in detail with reference to the accompanying drawings and the embodiments. The detailed description and the accompanying drawings of the following embodiments are used to exemplarily illustrate the principles of the present application, rather than being used to limit the scope of the present application. That is, the present application is not limited to the described embodiments.

In the description of the present application, it needs to be understood that, "a plurality of" has the meaning of two or more than two. Directions or location relationships indicated by terms such as "up", "down", "left", "right", "inside" and "outside", etc., are only intended to describe the present application conveniently and simplify the description of the present application, rather than indicating or implying that the indicated device or component must have specific locations or be constructed and operated according to specific locations. Thus, these terms shouldn't be considered as limitations to the present application. Additionally, terms "first", "second", "third", etc., are only used for description purposes, and cannot be interpreted as indicating or implying relative importance.

Self-discharge rate of a battery is an important index for measuring the performance of the battery. For example, when the self-discharge rate of a lithium ion battery exceeds a safety threshold value, a hidden danger may exist. Generally, a battery includes a plurality of cells, the self-discharge rate of the battery also refers to the self-discharge rate(s) of one or a plurality of cells included in the battery. For one single cell, the self-discharge rate of the cell can be measured by obtaining a state of charge (SOC) of the cell at a first time point, obtaining a SOC of the cell at a second time point, and determining a ratio of the difference value between the SOC at the first time point and the SOC at the second time point to a time interval between the first time point and the second time point.

A battery management system (BMS) may be arranged outside the battery or inside the battery. As can be understood by a person of ordinary skill in the art, the BMS may be configured to obtain parameter information of the battery, and manage and control the battery. For example, the BMS may obtain the SOC of the battery or the cell of the battery, and then control the charging and discharging of the battery according to the SOC. Taking an electric vehicle as an example, an electric vehicle generally includes a vehicle control unit (VCU), the VCU may be in communication connection with a BMS of a vehicle-mounted battery of the electric vehicle. In this way, the BMS may transmit related parameters of the vehicle-mounted battery to the VCU, the VCU may transmit a control command associated with the battery to the BMS so as to control the battery through the BMS. When the electric vehicle does not need to be used, the VCU and the BMS may enter a dormancy state or a power off state. Especially when the electric vehicle is not used for a long time, the vehicle-mounted battery may experience a self-discharge process without being used. If the self-discharge rate of the vehicle-mounted battery is abnormal, both the VCU and the BMS in the dormant state or the power-off state cannot acquire that the vehicle-mounted battery is in a state of abnormal self-discharge rate, a great security risk is existed.

In order to solve the aforementioned technical problems in the present application, one or a plurality of battery monitoring methods, one or a plurality of battery monitoring devices, one or a plurality of computer readable storage mediums, one or a plurality of batteries are provided in one or a plurality of embodiments of the present application. The one or more battery monitoring methods provided in the present application may be performed by the one or plurality of battery monitoring devices provided in the present application. The one or plurality of battery monitoring devices provided in the present application may include a battery management system (BMS), and may further include an analog front end (AFE). As can be understood by the person of ordinary skill in the art, the AFE may be communicatively connected to the BMS and transmit information to the BMS. The AFE may obtain information such as a temperature, a voltage, and a state of charge (SOC) of a cell of the battery, and then transmit the information to the BMS. The BMS may also obtain information including the temperature, the voltage and the SOC of the battery and/or the cell through sensors, and then send the information to the VCU. The structures and the models of the BMS and the AFE are not limited in the present application.

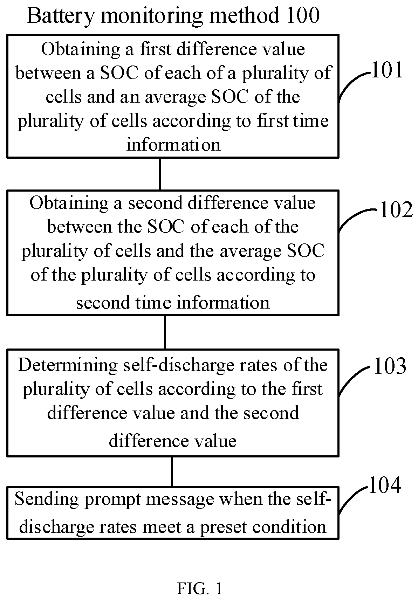

FIG. 1 illustrates a flow diagram of a battery monitoring method provided in one or multiple embodiments of the present application. Where the battery includes a plurality of cells. As shown in FIG. 1, the battery monitoring method 100 includes:
At step S101, a first difference value between a SOC of each of the plurality of cells and an average SOC of the plurality of cells is obtained according to first time information.

The present application is described by taking the AFE that performs the battery monitoring method as an example. In the step of S101, the AFE obtains the first difference value between the SOC of each of the plurality of cells of the battery and the average SOC of the plurality of cells according to the first time information. As an optional embodiment, the first time information corresponds to one time point. Accordingly, in the step S101, the AFE obtains the first difference value according to the time point. For example, the AFE obtains the first difference value at the time point.

For example, the battery includes M cells in total. M is an integer greater than or equal to 2. In the step S101, the AFE obtains M difference values between the M SOCs of the M cells and the average SOC of the M cells according to the first time information. The AFE may obtain M SOCs of the M cells at the first time point, and then determine an average SOC of the M cells according to the M SOCs (that is, dividing the sum of M SOCs by M), and then subtract the determined average SOC from the M SOCs of the M cells, respectively, to obtain the first difference value between the SOC of each cell in the M cells and the average SOC. The first difference value includes M difference values of the M cells. Optionally, the AFE may further obtain N difference values between the SOCs of the N cells in the M cells and the average SOC of the N cells. Where N is a positive integer less than M, for example, the AFE may obtain the N SOCs of the N cells at the first time point, and then determine the average SOC of each cell in the N cells according to the N SOCs (N), and in this case, the first difference value includes N difference values of the N cells.

At step S102, a second difference value between the SOC of each of the plurality of cells and the average SOC of the plurality of cells is obtained according to the second time information.

The present application is further described by taking the AFE that performs the battery monitoring method as an example. In the step of S102, the AFE obtains the second difference value between the SOC of each of the plurality of cells of the battery and the average SOC of the plurality of cells according to the second time information. As an optional embodiment, the second time information corresponds to one time point. Accordingly, in the step of S102, the AFE obtains the second difference value according to the time point. For example, the AFE obtains the second difference value at this time point.

Regarding the battery including M cells, in the step S102, the AFE obtains M difference values between the M SOCs of the M cells and the average SOC of the M cells according to the second time information. The AFE may obtain the M SOCs of the M cells at the second time point, and then determine the average SOC of the M cells according to the M SOCs (i.e., dividing the sum of the M SOCs by M), and then subtract the determined average SOC from the M SOCs of the M cells respectively to obtain the second difference value between the SOC of each of the M cells and the average SOC. The second difference value includes M difference values of the M cells. Optionally, the AFE may further obtain N difference values between SOCs of N cells in the M cells and the average SOC of the N cells. Where N is a positive integer less than M. For example, the AFE obtains the N SOCs of the N cells at the second time point, and then determines the average SOC of the N cells according to the N SOCs, and further subtracts the determined average SOC from the N SOCs of the N cells respectively to obtain the second difference value between the SOC of each of the N cells and the average SOC of the N cells. In this situation, the second different value includes N difference values of N cells.

At step S103, self-discharge rates of the plurality of cells are determined according to the first difference value and the second difference value.

The present application is further described by taking the AFE that performs the battery monitoring method as an example. In the step of S103, the AFE may determine the self-discharge rates of the plurality of cells according to the first difference values of the plurality of cells determined in the step S101 and the second difference values of the plurality of cells determined in the step S102. For example, the AFE may determine the self-discharge rates of the plurality of cells according to third difference values between the first difference values and the second difference values, and a time interval between the first time information and the second time information.

In an optional embodiment, the step S103 of determining the self-discharge rates of the plurality of cells according to the first difference value and the second difference value includes: determining a first time interval between the first time information and the second time information; determining a third difference value between the first difference value and the second difference value; and determining the self-discharge rates of the plurality of cells according to a ratio of the third difference value to the first time interval. For example, the AFE obtains M third difference values between the M first difference values and the M second difference values according to the M first difference values of the M cells obtained in step S101 and the M second difference values of the M cells obtained in the step S102. The AFE further determines the first time interval between the first time information and the second time information according to the first time information and the second time information, and then calculates M ratios of the M third difference values to the first time interval. The M ratios are the self-discharge rates of the M cells. Optionally, in the step S103, determining the first time interval between the first time information and the second time information includes: determining the first time interval according to a time point corresponding to the first time information and a second time point corresponding to the second time information. For example, the first time interval is determined according to a difference value between the first time point corresponding to the first time information and the second time point corresponding to the second time information.

At step S104, prompt message is sent when the self-discharge rates satisfy a preset condition.

The present application is further described by taking the AFE that performs the battery monitoring method as an example. In the step of S104, for the self-discharge rates of the plurality of cells in the step S103, the AFE sends the prompt message when the self-discharge rates of the plurality of cells satisfy the preset condition. Optionally, the preset condition includes: the self-discharge rates exceed a preset range or the self-discharge rates exceeds a threshold value. For example, for the plurality of cells of the battery, a preset range of self-discharge rate or a self-discharge threshold value is set for the plurality of cells after delivery of the battery. For the M self-discharge rates of the M cells determined in the step S103, the AFE determines whether the M self-discharge rates of the M cells exceed the preset range corresponding to the M cells or exceeds the threshold value (including that the self-discharge rates are greater than the threshold value or are less than the threshold value) in the step S104. The AFE sends the prompt message when the self-discharge rate(s) of one or multiple of the M cells exceed(s) the corresponding preset range or exceed(s) the threshold value.

In an optional embodiment, sending the prompt message includes sending prompt message to the BMS of the battery or the plurality of cells. For example, when the AFE determines that the self-discharge rates exceed the preset range or exceeds the threshold value in the step S104, the AFE may send the prompt message to the BMS, in order that the BMS performs a corresponding processing according to the prompt message.

In an optional embodiment, the prompt message prompts the BMS to enter a wake-up state from a dormant state. Alternatively, the prompt message prompts the BMS to enter the wake-up state from a power-off state. Taking the vehicle-mounted battery of the electric vehicle as an example. When the electric vehicle is powered off, for example, the BMS also enters the power-off state or the dormant state, and the AFE can be powered through some implementation methods (e.g., being powered by sampling cell), and thereby performing the battery monitoring method provided in the one of multiple embodiments of the present application. When the AFE determines in the step S104 that the self-discharge rate(s) of the one or plurality of cells in the M cells of the electric vehicle meets the preset condition, the AFE sends the prompt message to the BMS, in order that the BMS enters the wake-up state in response to receiving the prompt message. Thus, BMS can perform self-inspection operation on the vehicle-mounted battery to determine whether the vehicle-mounted battery has a hidden danger. Furthermore, when BMS determines that the vehicle-mounted battery has the hidden danger, BMS can give an alarm for notifying that measures should be taken to prevent a safety accident from occurring.

The battery monitoring method provided by the one or multiple embodiments of the present application can be performed by the AFE, and can also be performed by the BMS. For example, the steps S101-S104 are performed by the BMS, and the self-discharge rates of the plurality of cells of the battery are determined through the BMS, and the prompt message is sent when the self-discharge rates meet the preset condition. For example, the prompt message is sent to the VCU, in order that the VCU determines whether vehicle-mounted battery has a hidden danger.

According to the battery monitoring method provided in the one or multiple embodiments of the present application, the self-discharge rates of the plurality of cells included in the battery can be monitored, and the prompt message can be automatically sent when the self-discharge rates meet the preset condition. For example, when determining that the self-discharge rates are abnormal, the prompt message indicating that a battery or a cell having the abnormal self-discharge rate needs to be processed can be generated and sent out to improve the safety of usage of the battery.

In an optional embodiment, the first time information in the step S101 is related to the time when the BMS of the plurality of cells enters the dormant state or the power-off state. For example, the BMS of the battery (i.e., the BMS of the plurality of cells) enters the dormant state or enters the power-off state, the time point corresponding to the first time information includes the time point when the BMS enters the dormant state or enters the power-off state. As an alternative, the time point corresponding to the first time information includes a time point at which a preset time interval is passed after the time point when the BMS enters the dormant state or enters the power-off state. Optionally, the second time information in the step S102 is related to the time point when the BMS enters the dormant state or enters the power-off state. For example, the time point corresponding to the second time information includes the time point after the time point when the BMS enters the dormant state or enters the power-off state.

In yet another optional embodiment, the second time information in step S102 is related to the second time interval. The second time interval includes a time interval between a time when the BMS enters the dormant state and a time when the BMS enters the wake-up state from the dormant state. As an alternative, the second time interval includes a time interval between a time when the BMS enters the power-off state and a time when the BMS enters the wake-up state from the power-off state. For example, the BMS of the battery (i.e., a BMS of the plurality of cells) enters the dormant state or the power-off state, and enters the wake-up state from the dormant state or the power-off state after the second time interval. The time point corresponding to the second time information includes a time point in the second time interval. Optionally, the first time information in the step S101 is related to the second time interval.

As an example, the battery includes M cells, M is an integer greater than or equal to 2. In the step S101, the AFE obtains M SOCs of the M cells expressed as ${SOC}_{1}^{t 1} ∼ {SOC}_{M}^{t 1}$ at a first time point t1, and calculate an average SOC ${SOC}_{Avg}^{t 2} = {\sum }_{j = 1}^{M} {SOC}_{j}^{t 2} / M$ according to ${SOC}_{1}^{t 1} ∼ {SOC}_{M}^{t 1}$. Where, ${SOC}_{j}^{t 1}$ represents a SOC of a j-th cell of the M cells at the first time point t1, j is an integer and j ranges from 1 to M. Then, AFE calculates the first difference between the SOC of each of the M cells and the average SOC. For the j-th cell in the M cells, the first difference value is expressed as $Δ {SOC}_{j}^{t 1} = {SOC}_{j}^{t 1} - {SOC}_{Avg}^{t 1}$. In the step of S102, AFE obtains M SOCs ${SOC}_{1}^{t 2} ∼ {SOC}_{M}^{t 2}$ of the M cells at the second time point t2, and calculates an average SOC ${SOC}_{Avg}^{t 2} = {\sum }_{j = 1}^{M} {SOC}_{j}^{t 2} / M$ according to the M SOCs ${SOC}_{1}^{t 2} ∼ {SOC}_{M}^{t 2}$. Where ${SOC}_{j}^{t 2}$ represents the SOC of the j-th cell of the M cells at the second time point t2. Then, AFE calculates the second difference between the SOC of each of the M cells and the average SOC. For the j-th cell in the M cells, the second difference value between the SOC of the j-th cell and the average SOC is expressed as $Δ {SOC}_{j}^{t 2} = {SOC}_{j}^{t 2} - {SOC}_{Avg}^{t 2}$. In the step of S103, AFE calculates the self-discharge rate of each of the M cells according to the first difference value and the second difference value. For the j-th cell of the M cells, the self-discharge rate of the j-th cell is expressed as $Kj = Δ {SOC}_{j}^{t 2} - Δ {SOC}_{j}^{t 1} / t 2 - t 1 .$. In the step of S104, AFE sends the prompt message when determining that the self-discharge rate Kj of the j-th cell of the M cells exceeds the self-discharge rate threshold of the j-th cell after delivery.

A person of ordinary skill in the art can understand that the AFE and the BMS may obtain the SOC of the battery or the cell through any existing or future method. For example, the voltage and the temperature of the cell may be obtained through sensors, then, the SOC of the cell may be determined by looking up a table. For example, on the basis of determination of the SOCs of the cells through look up table, in order to improve the accuracy of the obtained SOC, an error caused due to an inaccurate voltage and/or temperature may also be reduced through SOC correction value. The acquisition of the SOC of the battery or the cell is not limited by the embodiments of the present application.

As one optional embodiment, said determining the first time interval of the first time information and the second time information includes: determining the first time interval according to a period length corresponding to the second time information. For example, the period length includes a period length and a period sequence number. As an example, the period length is 2 hours. After the step S101 is performed by the AFE, the steps S102-S104 may be periodically performed by taking 2 hours as the period length. Alternatively, the second difference value between the SOC of each of the plurality of cells and the average SOC of the plurality of cells is periodically obtained, and the self-discharge rates of the cells are further determined according to the third difference value between the first difference value and the second difference value, and the first time interval. Taking the period length as 2 hours as an example, the self-discharge rates of the plurality of cells are determined every 2 hours, and the prompt message is sent when the self-discharge rates meet a preset condition. The first time interval can be a product of the period sequence number corresponding to the second time information and the period length, and can also be a product of a difference value between the period sequence number corresponding to the second time information and the second period sequence number corresponding to the first time information, and the period length.

As an example, the period length is 2 hours and the maximum cycle number is 100. In the step of S101, AFE obtains the first difference value between the SOC of each of the plurality of cells and the average SOC of the plurality of cell in the first period. In the step of S102, AFE obtains the second difference value between the SOC of each of the plurality of cells and the average SOC of the plurality of cells in the n-th cycle (i.e. the period sequence number corresponding to the second time information is n), n is an integer greater than or equal to 1. In the step of S103, AFE determines the third difference value based on the second difference value and the first difference value, and determines the first time interval according to the period sequence number n and the period length of 2 hours. For example, the first time interval is (n-1) * 2 hours. Then, the ratio of the third difference value to the first time interval is taken as the self-discharge rates of the cells. As an optional embodiment, AFE or BMS may determine the second difference value between the SOC of each of the plurality of cells and the average SOC of the plurality of cells in each period, calculate the third difference value between the first difference value and the second difference value, and then determines the self-discharge rates of the cells according to the third difference value and the first time interval "(n-1) * period length", and send the prompt message when the self-discharge rates exceeds the threshold value. Further, AFE or BMS can update the first difference value according to the period sequence number corresponding to the second time information. For example, after the period sequence number of the second time information reaches the maximum period sequence number, the step S101 is performed again to obtain the first difference value between the SOC of each of the plurality of cells and the average SOC of the plurality of cells, and then calculate the self-discharge rates of the plurality of cells according to the new first difference value. The corresponding implementation steps can refer to the aforementioned descriptions and will not be repeatedly described herein.

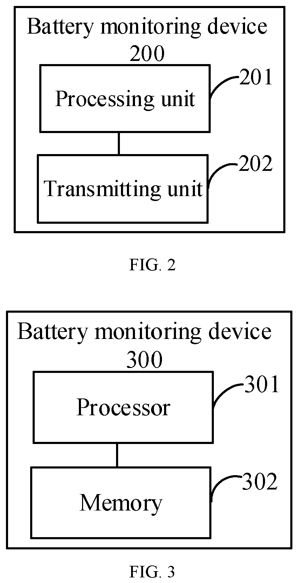

FIG. 2 illustrates a schematic structural diagram of a battery monitoring device provided in one or a plurality of embodiments of the present application. As shown in FIG. 2, the battery monitoring device 200 includes a processing unit 201 and a transmitting unit 202. The processing unit 201 is configured to obtain a first difference value between a state of charge (SOC) of each of a plurality of cells and an average SOC of the plurality of cells according to first time information. The processing unit 201 is further configured to obtain a SOC of each of the plurality of cells and a second difference value of an average SOC of the plurality of cells according to the second time information. Furthermore, the processing unit 201 is further configured to determine self-discharge rates of the plurality of cells according to the first difference value and the second difference value. The transmitting unit 202 is configured to send prompt message when the self-discharge rates meet a preset condition.

FIG. 3 illustrates a schematic structural diagram of yet another battery monitoring device provided in one or a plurality of embodiments of the present application. As shown in FIG. 3, the battery monitoring device 300 includes a processor 301 and a memory 302. The processor 301 causes the battery monitoring device 300 to implement the battery monitoring method provided in the one or plurality of embodiments by executing the computer instruction stored in the memory 302.

In addition, a computer readable storage medium is further provided in the embodiments of the present application. The computer readable storage medium is configured to store a computer program. When the computer program is executed by a computer, the method in the aforementioned various embodiments of the present application is implemented.

It should be understood that the specific examples described herein are only used to facilitate the person of ordinary skill in the art to better understand the embodiments of the present application, and are not intended to limit the scope of the embodiments of the present application which is defined in the appended claims.

It should be understood that, in the various embodiments of the present application, the values of serial numbers of the steps in the processes do not indicate an order of execution sequences of the steps. The execution sequences of these steps should be determined by functionalities and internal logics of these steps, and therefore shouldn't be regarded as limitation to the implementation processes of the embodiments of the present application which is defined in the appended claims.

## Claims

1. A battery monitoring method, the battery comprises a plurality of cells, wherein the battery monitoring method comprises steps of:
obtaining a first difference value between a state of charge (SOC) of each of a plurality of cells and an average SOC of the plurality of cells according to first time information;
obtaining a second difference value between the SOC of each of the plurality of cells and the average SOC of the plurality of cells according to second time information;
determining self-discharge rates of the plurality of cells according to the first difference value and the second difference value; and
sending prompt message when the self-discharge rates meet a preset condition;
wherein the prompt message prompts a battery management system (BMS) to enter a wake-up state from a dormant state; as an alternative, the prompt message prompts the BMS to enter the wake-up state from a power-off state.

2. The battery monitoring method according to claim 1, wherein the step of determining the self-discharge rate of each of the plurality of cells according to the first difference value and the second difference value comprises:
determining a first time interval between the first time information and the second time information;
determining a third difference value between the first difference value and the second difference value; and
determining the self-discharge rate of the plurality of cells according to a ratio of the third difference value to the first time interval.

3. The battery monitoring method according to claim 2, wherein the step of determining the first time interval between the first time information and the second time information comprises: determining the first time interval according to a time point corresponding to the first time information and a second time point corresponding to the second time information.

4. The battery monitoring method according to claim 2, wherein the step of determining the first time interval between the first time information and the second time information comprises: determining the first time interval according to a period length corresponding to the second time information.

5. The battery monitoring method according to any one of claims 1-4, wherein the first time information is related to a time when the BMS of the plurality of cells enters the dormant state or the power-off state.

6. The battery monitoring method according to claim 5, wherein the second time information is related to the second time interval, the second time interval includes a time interval between a time when the BMS enters the dormant state and a time when the BMS enters the wake-up state from the dormant state; as an alternative, the second time interval includes a time interval between a time when the BMS enters the power-off state and a time when the BMS enters the wake-up state from the power-off state.

7. The battery monitoring method according to any one of claims 1-6, wherein the preset condition comprises: the self-discharge rate exceeds a preset range or the self-discharge rate exceeds a threshold value.

8. A battery monitoring device, comprising a processor and a storage device, wherein the storage device stores a computer instruction, that, when executed by the processor, causes the battery monitoring device to implement the battery monitoring method according to any one of claims 1-7.

9. A computer readable storage medium, wherein the computer readable storage medium stores a computer instruction, that, when executed by a computing device, causes the computing device to implement the battery monitoring method according to any one of claims 1-7.

## Patentansprüche

1. Batterieüberwachungsverfahren, wobei die Batterie eine Mehrzahl von Zellen umfasst, wobei das Batterieüberwachungsverfahren Schritte umfasst:
Erhalten eines ersten Differenzwerts zwischen einem Ladezustand (SOC) jeder einer Mehrzahl von Zellen und einem durchschnittlichen SOC der Mehrzahl von Zellen gemäß einer ersten Zeitinformation;
Erhalten eines zweiten Differenzwerts zwischen dem SOC jeder der Mehrzahl von Zellen und dem durchschnittlichen SOC der Mehrzahl von Zellen gemäß einer zweiten Zeitinformation;
Bestimmen von Selbstentladungsraten der Mehrzahl von Zellen gemäß dem ersten Differenzwert und dem zweiten Differenzwert; und
Senden einer Hinweisnachricht, wenn die Selbstentladungsraten eine voreingestellte Bedingung erfüllen;
wobei die Hinweisnachricht ein Batteriemanagementsystem (BMS) auffordert, aus einem Ruhezustand in einen Aufwachzustand einzutreten; als Alternative fordert die Hinweisnachricht das BMS auf, aus einem Ausschaltzustand in den Aufwachzustand einzutreten.

2. Batterieüberwachungsverfahren nach Anspruch 1, wobei der Schritt des Bestimmens der Selbstentladungsrate jeder der Mehrzahl von Zellen gemäß dem ersten Differenzwert und dem zweiten Differenzwert umfasst:
Bestimmen eines ersten Zeitintervalls zwischen der ersten Zeitinformation und der zweiten Zeitinformation;
Bestimmen eines dritten Differenzwerts zwischen dem ersten Differenzwert und dem zweiten Differenzwert; und
Bestimmen der Selbstentladungsrate der Mehrzahl von Zellen gemäß einem Verhältnis des dritten Differenzwerts zu dem ersten Zeitintervall.

3. Batterieüberwachungsverfahren nach Anspruch 2, wobei der Schritt des Bestimmens des ersten Zeitintervalls zwischen der ersten Zeitinformation und der zweiten Zeitinformation umfasst: Bestimmen des ersten Zeitintervalls gemäß einem Zeitpunkt, der der ersten Zeitinformation entspricht, und einem zweiten Zeitpunkt, der der zweiten Zeitinformation entspricht.

4. Batterieüberwachungsverfahren nach Anspruch 2, wobei der Schritt des Bestimmens des ersten Zeitintervalls zwischen der ersten Zeitinformation und der zweiten Zeitinformation umfasst: Bestimmen des ersten Zeitintervalls gemäß einer Periodenlänge, die der zweiten Zeitinformation entspricht.

5. Batterieüberwachungsverfahren nach einem der Ansprüche 1-4, wobei die erste Zeitinformation mit einer Zeit in Beziehung steht, zu der das BMS der Mehrzahl von Zellen in den Ruhezustand oder den Ausschaltzustand eintritt.

6. Batterieüberwachungsverfahren nach Anspruch 5, wobei die zweite Zeitinformation mit dem zweiten Zeitintervall in Beziehung steht, wobei das zweite Zeitintervall ein Zeitintervall zwischen einer Zeit, zu der das BMS in den Ruhezustand eintritt, und einer Zeit, zu der das BMS aus dem Ruhezustand in den Aufwachzustand eintritt, beinhaltet; als Alternative beinhaltet das zweite Zeitintervall ein Zeitintervall zwischen einer Zeit, zu der das BMS in den Ausschaltzustand eintritt, und einer Zeit, zu der das BMS aus dem Ausschaltzustand in den Aufwachzustand eintritt.

7. Batterieüberwachungsverfahren nach einem der Ansprüche 1-6, wobei die voreingestellte Bedingung umfasst: die Selbstentladungsrate überschreitet einen voreingestellten Bereich oder die Selbstentladungsrate überschreitet einen Schwellenwert.

8. Batterieüberwachungseinrichtung, umfassend einen Prozessor und eine Speichereinrichtung, wobei die Speichereinrichtung eine Computeranweisung speichert, die, wenn sie durch den Prozessor ausgeführt wird, die Batterieüberwachungseinrichtung veranlasst, das Batterieüberwachungsverfahren nach einem der Ansprüche 1-7 zu implementieren.

9. Computerlesbares Speichermedium, wobei das computerlesbare Speichermedium eine Computeranweisung speichert, die, wenn sie durch eine Recheneinrichtung ausgeführt wird, die Recheneinrichtung veranlasst, das Batterieüberwachungsverfahren nach einem der Ansprüche 1-7 zu implementieren.

## Revendications

1. Procédé de surveillance de batterie, la batterie comprenant une pluralité de cellules, dans lequel le procédé de surveillance de batterie comprend des étapes consistant à :
obtenir une première valeur de différence entre un état de charge (SOC) de chacune d'une pluralité de cellules et un SOC moyen de la pluralité de cellules selon une première information temporelle ;
obtenir une deuxième valeur de différence entre le SOC de chacune de la pluralité de cellules et le SOC moyen de la pluralité de cellules selon une seconde information temporelle ;
déterminer des taux d'autodécharge de la pluralité de cellules selon la première valeur de différence et la deuxième valeur de différence ; et
envoyer un message d'invite lorsque les taux d'autodécharge satisfont à une condition prédéfinie ;
dans lequel le message d'invite invite un système de gestion de batterie (BMS) à entrer dans un état de réveil à partir d'un état dormant ; à titre d'alternative, le message d'invite invite le BMS à entrer dans l'état de réveil à partir d'un état hors tension.

2. Procédé de surveillance de batterie selon la revendication 1, dans lequel l'étape consistant à déterminer le taux d'autodécharge de chacune de la pluralité de cellules selon la première valeur de différence et la deuxième valeur de différence comprend :
déterminer un premier intervalle de temps entre la première information temporelle et la seconde information temporelle ;
déterminer une troisième valeur de différence entre la première valeur de différence et la deuxième valeur de différence ; et
déterminer le taux d'autodécharge de la pluralité de cellules selon un rapport de la troisième valeur de différence au premier intervalle de temps.

3. Procédé de surveillance de batterie selon la revendication 2, dans lequel l'étape consistant à déterminer le premier intervalle de temps entre la première information temporelle et la seconde information temporelle comprend : déterminer le premier intervalle de temps selon un point temporel correspondant à la première information temporelle et un second point temporel correspondant à la seconde information temporelle.

4. Procédé de surveillance de batterie selon la revendication 2, dans lequel l'étape consistant à déterminer le premier intervalle de temps entre la première information temporelle et la seconde information temporelle comprend : déterminer le premier intervalle de temps selon une longueur de période correspondant à la seconde information temporelle.

5. Procédé de surveillance de batterie selon l'une quelconque des revendications 1-4, dans lequel la première information temporelle est liée à un moment où le BMS de la pluralité de cellules entre dans l'état dormant ou l'état hors tension.

6. Procédé de surveillance de batterie selon la revendication 5, dans lequel la seconde information temporelle est liée au second intervalle de temps, le second intervalle de temps incluant un intervalle de temps entre un moment où le BMS entre dans l'état dormant et un moment où le BMS entre dans l'état de réveil à partir de l'état dormant ; à titre d'alternative, le second intervalle de temps inclut un intervalle de temps entre un moment où le BMS entre dans l'état hors tension et un moment où le BMS entre dans l'état de réveil à partir de l'état hors tension.

7. Procédé de surveillance de batterie selon l'une quelconque des revendications 1-6, dans lequel la condition prédéfinie comprend : le taux d'autodécharge dépasse une plage prédéfinie ou le taux d'autodécharge dépasse une valeur seuil.

8. Dispositif de surveillance de batterie, comprenant un processeur et un dispositif de stockage, dans lequel le dispositif de stockage stocke une instruction d'ordinateur, qui, lorsqu'elle est exécutée par le processeur, amène le dispositif de surveillance de batterie à mettre en œuvre le procédé de surveillance de batterie selon l'une quelconque des revendications 1-7.

9. Support de stockage lisible par ordinateur, dans lequel le support de stockage lisible par ordinateur stocke une instruction d'ordinateur, qui, lorsqu'elle est exécutée par un dispositif de calcul, amène le dispositif de calcul à mettre en œuvre le procédé de surveillance de batterie selon l'une quelconque des revendications 1-7.
